**Europäisches Patentamt**

**European Patent Office**

**Office européen des brevets**

(19)

(11) Publication number : **0 384 615 B1**

(12) # EUROPEAN PATENT SPECIFICATION

(45) Date of publication of patent specification :
07.07.93 Bulletin 93/27

(51) Int. Cl.⁵ : **G01R 21/14,** G01R 19/22,
G01R 19/32

(21) Application number : **90301316.7**

(22) Date of filing : **07.02.90**

(54) **Biasing circuitry for a diode detector.**

(30) Priority : **24.02.89 FI 890894**

(43) Date of publication of application :
**29.08.90 Bulletin 90/35**

(45) Publication of the grant of the patent :
**07.07.93 Bulletin 93/27**

(84) Designated Contracting States :
**AT BE CH DE DK ES FR GB GR IT LI LU NL SE**

(56) References cited :
**US-A- 3 011 116**
**US-A- 3 109 992**
**US-A- 3 329 896**

(73) Proprietor : **NOKIA MOBILE PHONES LTD.**
**P.O. Box 86**
**SF-24101 Salo (FI)**

(72) Inventor : **Saarnimo, Timo**
**Petäjätie 3F**
**S-24260 Salo (FI)**

(74) Representative : **Frain, Timothy John**
**Patent Department Nokia Mobile Phones**
**Ashwood House Pembroke Broadway**
**Camberley, Surrey GU15 3SP (GB)**

EP 0 384 615 B1

Jouve, 18, rue Saint-Denis, 75001 PARIS

## Description

Biasing circuitry for a diode detector

The invention relates to a biasing circuitry for a diode detector, having a circuit for compensation for the variation caused in the detector diode threshold voltage by temperature variation and for linearization of the power level detection.

The detector employed for detecting the power level of a high-frequency power amplifier is usually a rectifier diode, to the anode of which the high-frequency voltage to be detected, for example RF voltage, is applied and from the cathode of which a rectified voltage proportional to the applied voltage is obtained. In order for the detector to function also at low power levels, the rectifier diode must be biased in some manner, since the diode has a certain threshold voltage. This threshold voltage is also dependent on the temperature, and so any threshold voltage change caused by the temperature must also be taken into account in the biasing.

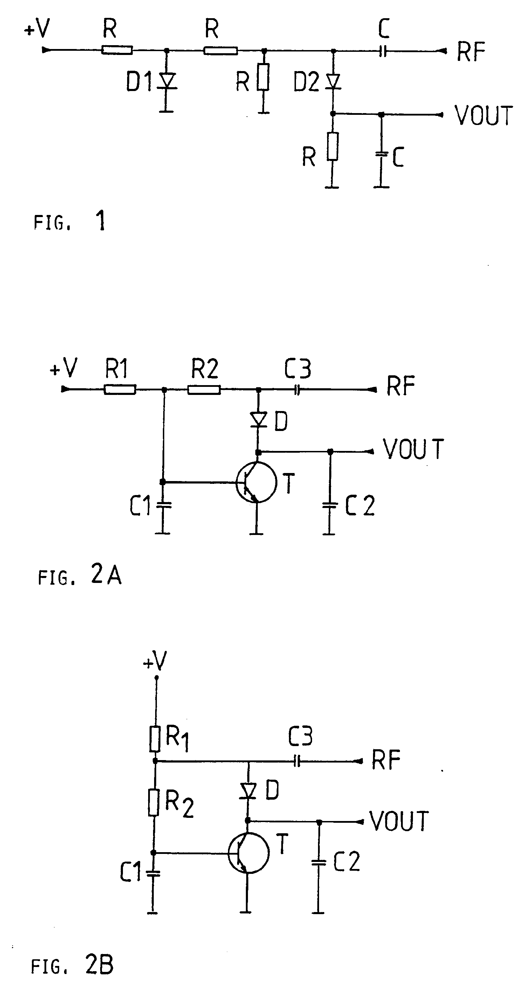

For compensating for the threshold voltage change caused by a temperature change it is known to use a second diode, which is biased forward and from which the voltage is fed via a resistor to the detector diode as its bias voltage. The variation of the detector diode threshold voltage with changes of temperature is compensated for when the voltage over the other diode changes in the same manner, provided that the diodes are at the same temperature and have the same temperature coefficient. An example of a prior-art circuitry such as this is depicted in Figure 1. The operation of the circuit is simple. From the voltage source V+, via a high resistor R, there is applied to the diode a voltage which is somewhat higher than its threshold voltage.

The diode D1 conducts and maintains to the next voltage divider the voltage at the level of the forward voltage. From the voltage divider there is obtained the detector diode D2 bias voltage, which is slightly lower than the threshold voltage. When the temperature rises, the threshold voltage of the diode D1 decreases, and thus also the bias voltage of the diode D2. Thus the difference between the bias voltage and the threshold voltage of diode D2 remains rather precisely constant, regardless of the temperature.

An example of temperature compensation using an additional diode is known from US-A-3011 116, which constitutes prior art relevant to the present application.

This known compensation circuitry for a detector diode bias voltage has the disadvantage that the detected voltage received from the detector diode is proportional to the RF voltage of the high-frequency signal, i.e. to the square root of the high-frequency power. For the linearity of the power control it would be desirable to obtain a voltage proportional to the power.

According to the invention a biasing circuitry for a diode detector, has a circuit for compensating for the variation caused in the detector diode threshold voltage by temperature changes and for linearization of the detection of the power level, characterized in that the circuit contains a constant-current source by means of which the operating point of the detector diode (D) is set at a constant level.

A small constant current is fed by using the constant-current source via the detector diode in such a manner that the diode is biased close to the angle point of the threshold voltage. Since the biasing is effected by using constant current, the variations of the diode threshold voltage according to the temperature will not affect the operating point of the detector diode. The constant-current source can be thought of as a load the current of which is constant. In this case, at low voltage levels the resistance of the load is low and at high voltage levels it is high. This phenomenon straightens the power/voltage curve of the detector diode at low power levels, whereupon the detected voltage is better proportional to the high-frequency power than in the case of prior-art circuitry.

An example of the invention will now be described with reference to the drawings, in which:

Figure 1 depicts a prior-art biasing circuitry,

Figure 2A depicts one biasing circuitry according to the invention,

Figure 2B depicts another embodiment of the circuitry according to the invention,

Figure 3A depicts in the form of a table the power obtained from the detector, as a function of RF power, when using prior art technology and when using the biasing circuitry according to one embodiment of the invention.

Figure 3B is a graphical representation of the table of Figure 3A, and

Figure 4 depicts the current/voltage curves of the detector diode at different temperatures.

The prior-art technique depicted in Figure 1 was already described above. In the biasing circuitry depicted in Figure 2A, the constant-current source is implemented by using two resistors R1, R2 and one transistor T. The magnitude of the current passing through the detector diode D and the transistor T is determined by means of resistor R1; the magnitude of the current remains sufficiently constant in spite of temperature variations, if the voltage source V is sufficiently high as compared with the base emitter voltage of the transistor T. In the circuitry, the transistor T is the source of current, the current of which is hardly dependent on the level of the rectified voltage Vout. The purpose of resistor R2 is to separate the bias circuit from the high-frequency signal. In addition, by means of resistor R2 it is possible to adjust the rectified voltage level in the detector output Vout to a sufficiently low level, for example 50 mV (without the high-frequency signal). The purpose of capacitors C1 and C2 is to filter out the high-frequency signal from the rectified voltages. By means of capacitor C3 the high-frequency signal is coupled to the detector diode. During the positive half cycles of the RF signal, the detector diode D is in the conducting state, charging the capacitor C2. Thus a voltage Vout proportional to the high-frequency signal is obtained.

The circuitry depicted in Figure 2B has the property that the voltage Vout without the high-frequency signal is higher than in the circuitry of Figure 2A. This is due to the fact that the anode of the detector diode D is in a higher potential between the resistors R1 and R2. In both circuitries, resistor R2 can be replaced with, for example, inductance L, by means of which the access of the high-frequency signal to the base of the transistor T is prevented.

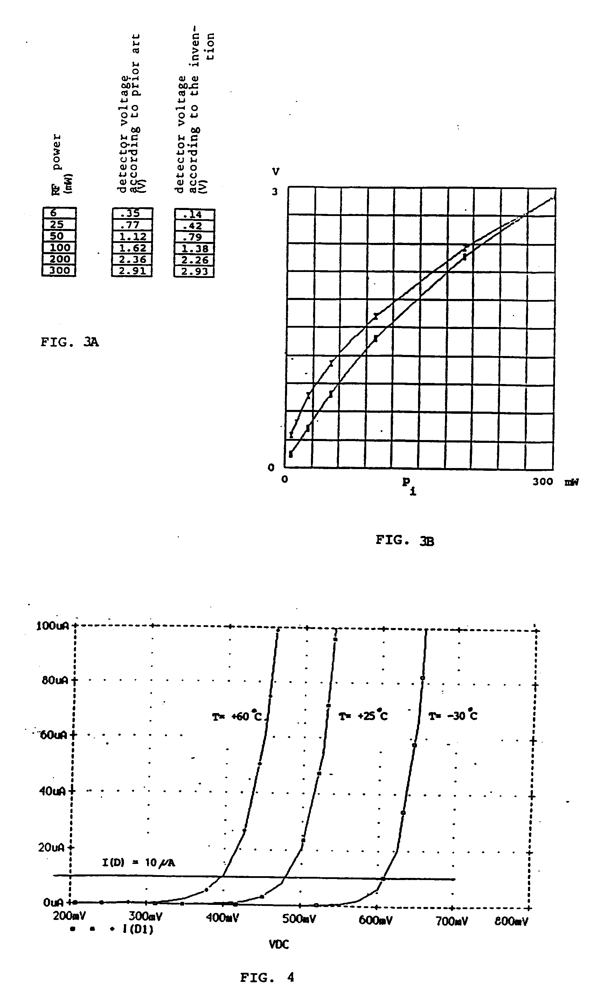

Figure 3A depicts in the form of a table the power/voltage values of the detector diode. It can be calculated from the table that in the prior-art detector diode circuitry the voltage $v_i$ is rather precisely proportional to the square root of the power $p_i$, approximately $v_i \approx 6\sqrt{P_i}$. From the curves in Figure 3B it can be seen that the power/voltage curve of the detector diode is at its lower end straighter than that of the prior-art circuit. In the circuit the detected voltage is thus more linearly proportional to the power of the high-frequency signal. This is due to the loading effect of the detector diode bias current on the detected rectified voltage level at the lower end of the voltage range. If the constant-current source is thought of as a load the current of which is constant, then the effective resistance of the load must be proportional to the voltage. In this case, at low voltage levels the resistance of the load is low and at high voltages it is high. This phenomenon straightens the power/voltage curve of the detector diode at low power levels, as can be seen from the lower curve in Figure 3B.

It can be seen from the characteristic curves in Figure 4 that, when a small constant current of approximately 10 microamperes is fed through the detector diode, the diode is biased close to the angle point of the threshold voltage. Since the biasing is implemented using a constant current, variations of the diode threshold voltage according to the temperature will not affect the operating point of the detector diode.

By using this circuitry it is possible to produce in a simple manner a detector signal which is proportional to the high-frequency power and in which any variations caused in the detector diode threshold voltage by temperature changes are compensated for. Owing to the circuitry, the detection of the power level is more linear than when a prior-art circuitry is used.

The practical implementation of the circuit may vary in different ways; the only thing that is essential is that a constant current by means of which the operating point is set at a constant level is fed through the detector diode.

## Claims

1. A biasing circuitry for a diode detector, having a circuit for compensating for the variation caused in the detector diode (D) threshold voltage by temperature changes and for linearization of the detection of the power level, **characterized** in that the circuit contains a constant-current source (T, $R_1$, $R_2$) by means of which the operating point of the detector diode (D) is set at a constant level.

2. A circuitry according to Claim 1, **characterized** in that the constant-current source (T, $R_1$, $R_2$) comprises a transistor (T) and two resistors (R1 and R2).

3. A circuitry according to Claim 2, **characterized** in that the detector diode (D) is in the collector circuit of the transistor (T).

4. A circuitry according to Claim 1, **characterized** in that the constant-current source feeds through the detector diode (D) a constant current by means of which the diode is biased close to the angle point of the threshold voltage.

5. A circuitry according to Claim 2, **characterized** in that the circuitry is used in a biasing circuitry of a power level detector used for high-frequency amplifier power control.

## Patentansprüche

1. Vorspannkreis für einen Diodendetektor mit einer Schaltung zum Ausgleichen der Abweichung in der Schwellenspannung der Detektordiode (D) und zum Linearisieren der Leistungspegelermittlung,
   *dadurch gekennzeichnet*, daß die Schaltung eine Konstantstromquelle (T, $R_1$, $R_2$) enthält, mit der der Arbeitspunkt der Detektordiode (D) auf einen konstanten Pegel eingestellt wird.

2. Schaltkreis nach Anspruch 1, *dadurch gekennzeichnet*, daß die Konstantstromquelle (T, $R_1$, $R_2$) einen Transistor (T) und zwei Widerstände (R1 und R2) umfaßt.

3. Schaltkreis nach Anspruch 2, *dadurch gekennzeichnet*, daß sich die Detektordiode (D) im Kollektorkreis des Transistors (T) befindet.

**4.** Schaltkreis nach Anspruch 1, ***dadurch gekennzeichnet***, daß die Konstantstromquelle einen konstanten Strom durch die Detektordiode (D) führt, mit dem die Diode nahe dem Kniepunkt der Schwellenspannung vorgespannt wird.

**5.** Schaltkreis nach Anspruch 2, ***dadurch gekennzeichnet***, daß der Schaltkreis in einem Vorspannkreis eines zur Leistungsregelung von Hochfrequenzverstärkern verwendeten Leistungspegel-Detektors verwendet wird.


**Revendications**

**1.** Circuit de polarisation pour un détecteur à diode, comportant un circuit pour corriger la variation provoquée dans la tension de seuil de la diode détectrice (D) par des changements de température et pour rendre linéaire la détection du niveau de puissance, caractérisé en ce que le circuit contient une source à courant constant (T, R1, R2) au moyen de laquelle le point de fonctionnement de la diode détectrice (D) est maintenu à un niveau constant.

**2.** Circuit selon la revendication 1, caractérisé en ce que la source à courant constant (T, R1, R2) comprend un transistor (T) et deux résistances (R1 et R2).

**3.** Circuit selon la revendication 2, caractérisé en ce que la diode détectrice (D) est dans le circuit collecteur du transistor (T).

**4.** Circuit selon la revendication 1, caractérisé en ce que la source à courant constant délivre à la diode détectrice (D) un courant constant au moyen duquel la diode est polarisée près du point d'origine de la tension de seuil.

**5.** Circuit selon la revendication 2, caractérisé en ce que le circuit est utilisé dans un circuit de polarisation d'un détecteur de niveau de puissance utilisé pour la commande de puissance d'un amplificateur à haute fréquence.

FIG. 1

FIG. 2A

FIG. 2B

| RF power (mW) | detector voltage according to prior art (V) | detector voltage according to the invention (V) |
|---|---|---|
| 6 | .35 | .14 |
| 25 | .77 | .42 |
| 50 | 1.12 | .79 |
| 100 | 1.62 | 1.38 |
| 200 | 2.36 | 2.26 |
| 300 | 2.91 | 2.93 |

FIG. 3A

FIG. 3B

FIG. 4